(19) Europäisches Patentamt / European Patent Office / Office européen des brevets

(11) **EP 3 358 691 A1**

(12) **EUROPEAN PATENT APPLICATION**

(43) Date of publication:
08.08.2018 Bulletin 2018/32

(51) Int Cl.:
H02H 1/00 (2006.01)    H02H 7/26 (2006.01)
H02J 3/38 (2006.01)

(21) Application number: 17202104.0

(22) Date of filing: 16.11.2017

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 03.02.2017   JP 2017018968

(71) Applicant: Omron Corporation
Kyoto-shi, Kyoto 600-8530 (JP)

(72) Inventors:
• TOMITA, Kohei
Kyoto-shi, Kyoto 600-8530 (JP)
• SANO, Akihiko
Kyoto-shi, Kyoto 600-8530 (JP)
• van ZWAM, Arno
2132 JD Hoofddorp (NL)

(74) Representative: Becker Kurig Straus
Patentanwälte
Bavariastrasse 7
80336 München (DE)

(54) **ARC DETECTION APPARATUS**

(57)    To detect an electric arc of a photovoltaic power generation system including an optimizer. In a photovoltaic power generation system (1), a solar battery string (11a) is connected to a string optimizer (22) via power lines (17a, 18a), and a solar battery string (11b) is connected to the string optimizer (22) via power lines (17c, 18c). The string optimizer (22) is connected to a PCS (13) via power lines (17b, 18b). In an arc detection apparatus (61), capacitors (19, 20, 71a) form a bypass current route bypassing the string optimizer (22), and a current sensor (31) is provided in the power line (18b).

FIG. 1

EP 3 358 691 A1

**Description**

BACKGROUND OF THE INVENTION

Field of the Invention

The present invention relates to an arc detection apparatus applied to a direct current power supply system.

Description of Related Art

A photovoltaic power generation system includes a solar battery array. The solar battery array is configured to have a plurality of solar battery strings connected in parallel. Each of the solar battery strings is configured to have a plurality of solar battery modules connected in series. As an example, direct current power generated in each of the solar battery strings is converted into suitable direct current power and/or suitable alternating current power by a power conditioning system (PCS).

In such a photovoltaic power generation system, sometimes an arc is generated due to a malfunction of a circuit or the like inside the system. When an arc is generated, the temperature of the arced part becomes high, and there is a risk of fire or the like. Therefore, the photovoltaic power generation system includes an arc detection apparatus which detects generation of an arc by causing a current sensor to sense an alternating current of an arc.

Patent Document 1 discloses a configuration in which power generated in a solar battery (photovoltaic generator) is supplied to an inverter via a DC power line. A current sensor is provided in the DC power line, and the presence or absence of generation of an arc is detected based on an alternating current sensed by the current sensor.

[Prior Art Document]

[Patent Documents]

[Patent Document 1] PCT Japanese Translation Patent Publication No. 2014-509396
[Patent Document 2] PCT Japanese Translation Patent Publication No. 2010-521720
[Patent Document 3] PCT Japanese Translation Patent Publication No. 2012-510158

SUMMARY OF THE INVENTION

Recently, in photovoltaic power generation systems, in order to more efficiently convert solar energy into power, an optimizer performing optimization of power, which has been performed using a PCS, in a solar battery string unit or a solar battery module unit is being utilized. Patent Documents 2 and 3 disclose specific configurations of such optimizers.

However, when an arc is generated in a photovoltaic power generation system provided with such an optimizer, it is difficult for a current sensor to detect an alternating current of an arc. This is because the optimizer includes a DC-DC converting circuit. The DC-DC converting circuit converts a direct current voltage through a conversion method such as a chopper type, a fly-back type, and a forward type. However, all the conversion methods include a coil (inductor) in a circuit. Therefore, an alternating current component of an arc is reduced. In addition, since a capacitor is inserted into the circuit for voltage stabilization, a high frequency component of the alternating current of the arc flows due to the capacitor. As a result, no alternating current of an arc flows in the current sensor.

Therefore, an object of an aspect of the present invention is to provide an arc detection apparatus which can detect an electric arc generated in a direct current power supply system such as a photovoltaic power generation system even if an optimizer is present.

In order to solve the problems, according to an aspect of the present invention, there is provided an arc detection apparatus applied to a direct current power supply system including a plurality of direct current power sources for power generation or charging/discharging, an optimizer that optimizes output of the plurality of direct current power sources, a loading device that consumes or converts output power of the optimizer, a plurality of pairs of first power lines that connect the plurality of direct current power sources and the optimizer, and a pair of second power lines that connect the optimizer and the loading device. Each of the plurality of pairs has an inter-power source capacitor of which one end portion is connected to one of a certain pair of first power lines and of which the other end portion is connected to one of a different pair of first power lines. The arc detection apparatus includes a first capacitor of which one end portion is connected to one of the two first power lines having no inter-power source capacitor connected thereto and of which the other end portion is connected to one of the pair of second power lines, a current measuring part which measures a current in the second power lines, and an arc determining part which determines the presence or absence of an arc based on a high frequency component of an alternating current measured by the current measuring part.

According to the configuration, the plurality of direct current power sources are connected to the optimizer via the plurality of pairs of first power lines respectively, and the optimizer is connected to the loading device via the second power lines. The first capacitor forms a first bypass current route bypassing the optimizer, and the inter-power source capacitor forms an inter-power source bypass current route bypassing the optimizer. The current measuring part measures a current in the second power lines.

Therefore, even when the optimizer is present, the current measuring part in the second power lines can measure the alternating current of an arc generated in the plurality of direct current power sources. Accordingly, even when the optimizer is present in the direct current power supply system, the arc detection apparatus can detect an arc generated in the direct current power supply system.

The first capacitor and the inter-power source capacitor may be provided outside the optimizer and may be provided inside the optimizer.

In the arc detection apparatus according to the aspect, it is preferable that an impedance between the first capacitor and the inter-power source capacitor satisfy a condition that a joint impedance constituted of the impedance between the first capacitor and the inter-power source capacitor, an impedance of the optimizer between the two first power lines having no inter-power source capacitor connected thereto and the pair of second power lines, an impedance of the optimizer between the pair of second power lines, an impedance of the loading device, and an impedance of the optimizer between the first power lines each of which is provided with the inter-power source capacitor is smaller than any of the impedances of the optimizer between the pairs of first power lines. In this case, the amount of an alternating current flowing in the first capacitor and the inter-power source capacitor is greater than the amount of an alternating current flowing in the optimizer. Therefore, it is possible to reliably detect an arc generated in the direct current power supply system.

The arc detection apparatus according to the aspect may further include a plurality of coils each of which is provided between a connection portion of the first capacitor in the first power lines and the inter-power source capacitor, and an input portion of the optimizer. In this case, the alternating current flowing in the first bypass current route and the inter-power source bypass current route increases, and the alternating current flowing in the current measuring part increases. As a result, it is possible to accurately detect an arc generated in the direct current power supply system. The coils may be provided inside the optimizer or may be provided outside the optimizer.

Incidentally, depending on the optimizer, there are cases where the impedance of the optimizer between the other one of the two first power lines having no inter-power source capacitor connected thereto and the other one of the second power lines becomes significant.

Therefore, the arc detection apparatus according to the aspect may further include a second capacitor of which one end portion is connected to the other one of the two first power lines and of which the other end portion is connected to the other one of the pair of second power lines. In this case, the second capacitor forms a second bypass current route bypassing the optimizer. Therefore, even if the impedance of the optimizer between the other one of the two first power lines and the other one of the second power lines is significant, the current measuring part in the second power lines can measure the alternating current of an arc generated in the plurality of direct current power sources. Accordingly, even when the optimizer is present in the direct current power supply system, the arc detection apparatus can detect an arc generated in the direct current power supply system.

In the arc detection apparatus according to the aspect, it is preferable that an impedance among the first capacitor, the second capacitor, and the inter-power source capacitor satisfy a condition that a joint impedance constituted of the impedance among the first capacitor, the second capacitor, and the inter-power source capacitor, the impedance of the optimizer between the two first power lines having no inter-power source capacitor connected thereto and the pair of second power lines, the impedance of the optimizer between the pair of second power lines, the impedance of the loading device, and the impedance of the optimizer between the first power lines each of which is provided with the inter-power source capacitor is smaller than any of the impedances of the optimizer between the pairs of first power lines. In this case, the amount of an alternating current flowing in the first capacitor, the second capacitor, and the inter-power source capacitor is greater than the amount of an alternating current flowing in the optimizer. Therefore, it is possible to reliably detect an arc generated in the direct current power supply system.

The arc detection apparatus according to the aspect may further include a coil between a connection portion of the second capacitor in the first power lines and the input portion of the optimizer. In this case, the alternating current flowing in the second bypass current route increases, and the alternating current flowing in the current measuring part increases. As a result, it is possible to accurately detect an arc generated in the direct current power supply system. The coil may be provided inside the optimizer or may be provided outside the optimizer.

According to the aspect of the present invention, the first capacitor forms the first bypass current route bypassing the optimizer, and the inter-power source capacitor forms the inter-power source bypass current route bypassing the optimizer. Therefore, even when the optimizer is present in the direct current power supply system, the current measuring part in the second power lines can measure the alternating current of an arc generated in the plurality of direct current power sources. Accordingly, the arc detection apparatus can detect an arc generated in the direct current power supply system.

BRIEF DESCRIPTION OF THE DRAWINGS

Fig. 1 is a schematic circuit diagram illustrating a configuration of a photovoltaic power generation system including an arc detection apparatus according to an embodiment of the present invention.
Fig. 2 is a block diagram illustrating a configuration of an arc detection processing part of the arc detection apparatus included in the photovoltaic power generation system.
Fig. 3a is a graph illustrating a waveform of an alternating current in a non-arc generative state and an arc generative state in a preceding stage of a string optimizer in the photovoltaic power generation system.
Fig. 3b is a graph illustrating a waveform of an alternating current in a non-arc generative state and an arc generative state in a succeeding stage of the string optimizer.
Fig. 4a is a waveform chart illustrating an FFT processing waveform of a current sensed by a current sensor in the arc detection apparatus when no arc is generated in the photovoltaic power generation system.
Fig. 4b is a waveform chart illustrating an FFT processing waveform of a current sensed by the current sensor when an arc is generated in the photovoltaic power generation system.
Fig. 5 is a schematic circuit diagram illustrating a configuration of the photovoltaic power generation system including an arc detection apparatus according to another embodiment of the present invention.
Fig. 6 is a schematic circuit diagram illustrating a configuration of the photovoltaic power generation system including an arc detection apparatus according to further another embodiment of the present invention.
Fig. 7 is a schematic circuit diagram illustrating a configuration of the photovoltaic power generation system including an arc detection apparatus according to an alternative embodiment of the present invention.

DESCRIPTION OF THE EMBODIMENTS

Hereinafter, embodiments of the present invention will be described in detail. For convenience of description, the same reference signs will be applied to members having the same functions illustrated in each of the embodiments, and the description thereof will be suitably omitted.

[Embodiment 1]

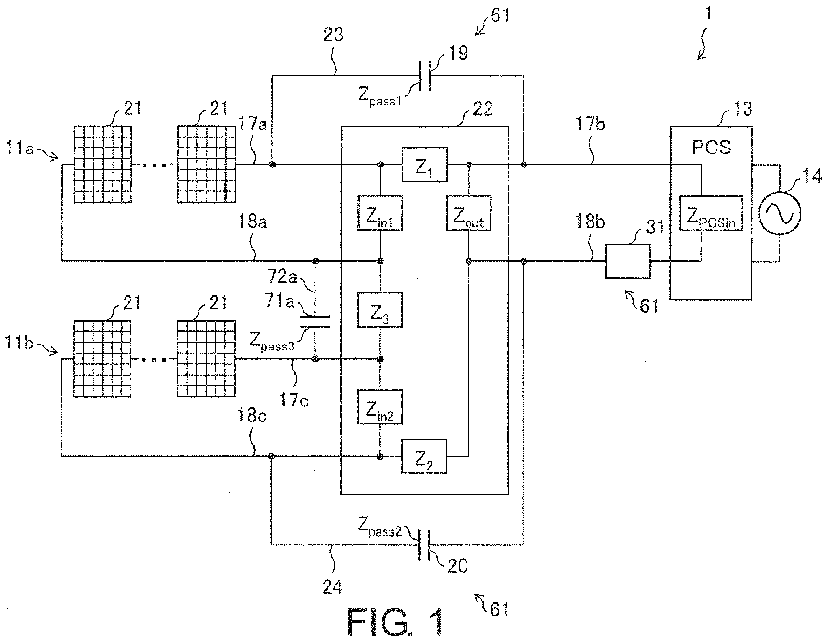

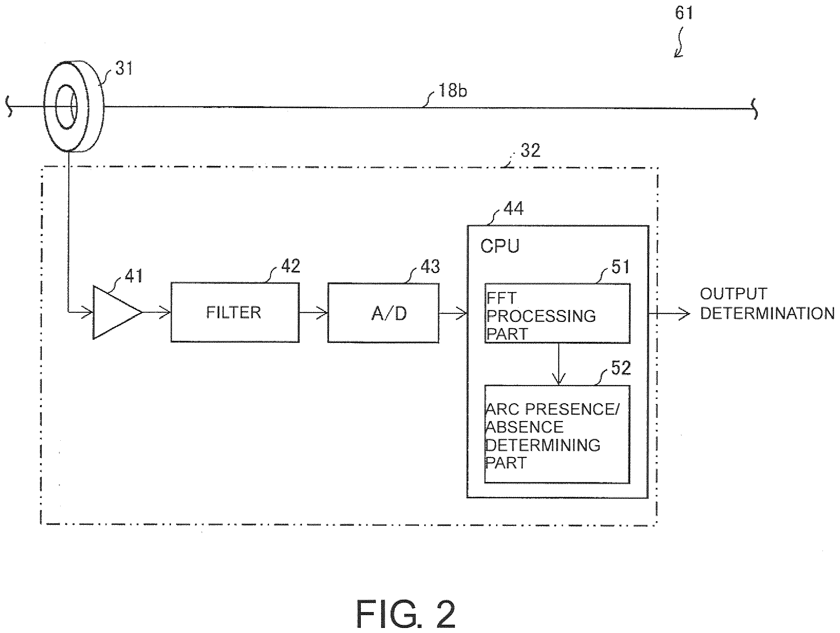

Fig. 1 is a schematic circuit diagram illustrating a configuration of a photovoltaic power generation system including an arc detection apparatus according to an embodiment of the present invention. Fig. 2 is a block diagram illustrating a configuration of an arc detection processing part of the arc detection apparatus included in the photovoltaic power generation system illustrated in Fig. 1.

(Configuration of Photovoltaic Power Generation System 1)

As illustrated in Fig. 1, a photovoltaic power generation system 1 (direct current power supply system) includes solar battery strings 11a and 11b (direct current power sources), a string optimizer 22 (optimizer), and a power conditioning system (hereinafter, will be referred to as a PCS) 13 (loading device).
In each of the solar battery strings 11a and 11b, many solar battery modules 21 connected in series are formed. Each of the solar battery modules 21 includes a plurality of solar battery cells (not illustrated) formed in a panel shape connected in series.
The solar battery string 11a is connected to the string optimizer 22 through a power line 17a on a P-side and a power line 18a on an N-side serving as a pair of power circuits (pair of first power lines). In addition, the solar battery string 11b is connected to the string optimizer 22 through a power line 17c on the P-side and the power line 18c on the N-side serving as another pair of power circuits (pair of first power lines).
The string optimizer 22 is connected to the PCS 13 through a power line 17b on the P-side and a power line 18b on the N-side serving as another pair of power circuits (pair of second power lines). The string optimizer 22 optimizes power from the solar battery strings 11a and 11b and supplies output power to the power lines 17b and 18b. Accordingly, it is possible to improve an efficiency of outputting power from the solar battery strings 11a and 11b to the PCS 13.
In the PCS 13, direct current power input from the solar battery strings 11a and 11b via the string optimizer 22 is converted into alternating current power and the converted alternating current power is output to a power system 14 (loading device). In place of the PCS 13, a loading device consuming the direct current power may be provided.

(Configuration of Arc Detection Apparatus)

The photovoltaic power generation system 1 includes an arc detection apparatus 61. The arc detection apparatus 61 includes bypass current routes 23, 24, and 72a, capacitors 19, 20, and 71a, a current sensor 31 (current measuring part), and an arc detection processing part 32 (arc determining part) (refer to Fig. 2).

In the bypass current route 23, a first end portion (one end portion) is connected to the power line 17a (one of the first power lines having no inter-power source capacitor connected thereto) between the string optimizer 22 and the solar battery string 11a, and a second end portion (the other end portion) is connected to the power line 17b (one of the pair of second power lines) between the string optimizer 22 and the PCS 13, such that the bypass current route 23 bypasses the string optimizer 22.

The capacitor 19 (first capacitor) is provided in the bypass current route 23. That is, in the capacitor 19, a first electrode is connected to the power line 17a, and a second electrode is connected to the power line 17b, thereby forming the bypass current route 23. The static capacitance (impedance) of the capacitor 19 will be described below.

In the bypass current route 24, a first end portion (one end portion) is connected to the power line 18c (the other one of the first power lines having no inter-power source capacitor connected thereto) between the string optimizer 22 and the solar battery string 11b, and a second end portion (the other end portion) is connected to the power line 18b (the other one of the pair of second power lines) between the string optimizer 22 and the PCS 13, such that the bypass current route 24 bypasses the string optimizer 22.

The capacitor 20 (second capacitor) is provided in the bypass current route 24. That is, in the capacitor 20, a first electrode is connected to the power line 18c, and a second electrode is connected to the power line 18b, thereby forming the bypass current route 24. The static capacitance (impedance) of the capacitor 20 will be described below.

In the bypass current route 72a, a first end portion (one end portion) is connected to the power line 18a (one of a certain pair of first power lines) between the string optimizer 22 and the solar battery string 11 a, and a second end portion (the other end portion) is connected to the power line 17c (one of a different pair of first power lines) between the string optimizer 22 and the solar battery string 11b, such that the bypass current route 72a bypasses the string optimizer 22.

The capacitor 71a (inter-power source capacitor) is provided in the bypass current route 72a. That is, in the capacitor 71 a, the first electrode is connected to the power line 18a, and the second electrode is connected to the power line 17c, thereby forming the bypass current route 72a. The static capacitance (impedance) of the capacitor 71a will be described below.

The current sensor 31 senses an alternating current flowing from the power line 18c to the power line 18b via the bypass current route 24 based on an arc generated in the solar battery string 11a or the solar battery string 11b. The current sensor 31 may be provided in the power line 17b. In this case, the current sensor 31 senses an alternating current flowing from the power line 17a to the power line 17b via the bypass current route 23 based on the arc.

The arc detection processing part 32 has a configuration known in the related art. For example, as illustrated in Fig. 2, the arc detection processing part 32 includes an amplifier 41, a filter 42, an A/D converter 43, and a central processing unit (CPU) 44.

The amplifier 41 amplifies a current sensed by the current sensor 31. The filter 42 is a band-pass filter (BPF) allowing a current only within a predetermined frequency range among currents output from the amplifier 41 to pass through. Accordingly, among the currents output from the amplifier 41, it is possible to eliminate a current having a frequency component containing plenty of switching noise of a converter (DC-DC converter) included in the PCS 13. The A/D converter 43 converts an analog signal of a current which has passed through the filter 42 into a digital signal and inputs the digital signal to the CPU 44.

The CPU 44 includes an FFT processing part 51 and an arc presence/absence determining part 52. The FFT processing part 51 performs FFT (Fast Fourier Transform) with respect to a digital signal of a current input from the A/D converter 43 and generates a power spectrum of the current. The arc presence/absence determining part 52 determines the presence or absence of generation of an arc based on the power spectrum of the current generated by the FFT processing part 51.

(Operations of Photovoltaic Power Generation System 1 and Arc Detection Apparatus 61)

Operations of the photovoltaic power generation system 1 and the arc detection apparatus 61 in the configuration described above will be described below.

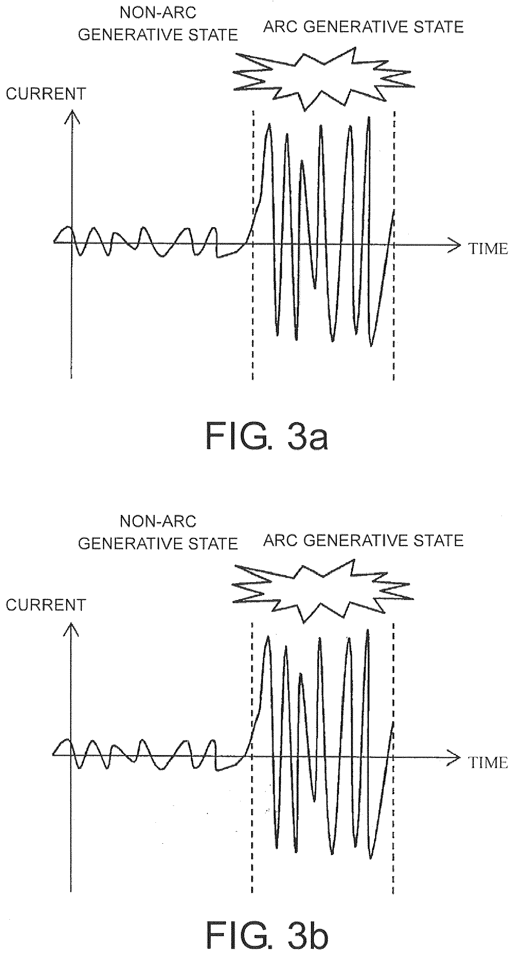

Fig. 3a is a graph illustrating a waveform of an alternating current in a non-arc generative state and an arc generative state in a preceding stage (solar battery strings 11 a and 11b side) of the string optimizer 22. Fig. 3b is a graph illustrating a waveform of an alternating current in a non-arc generative state and an arc generative state in a succeeding stage (PCS 13 side) of the string optimizer 22.

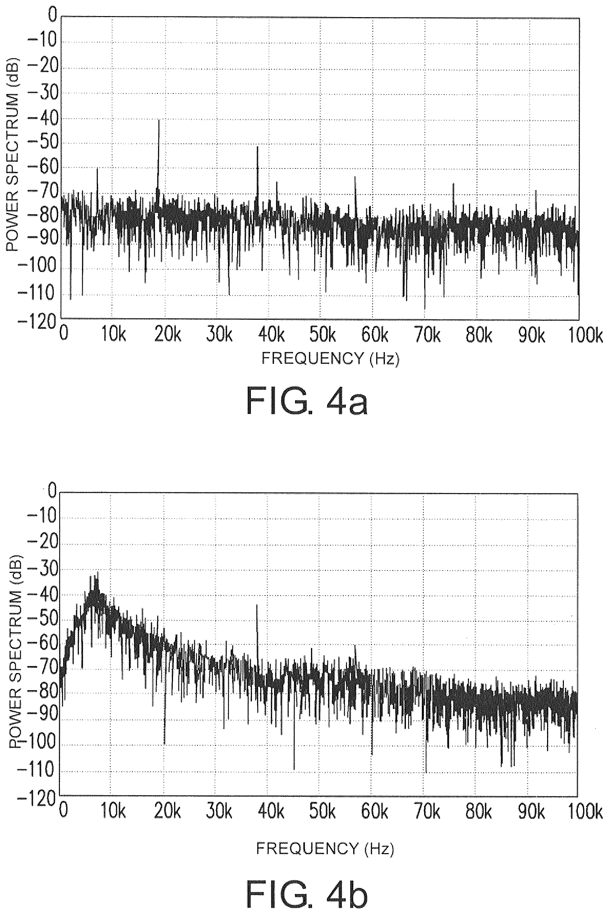

Fig. 4a is a waveform chart illustrating an FFT processing waveform of a current sensed by the current sensor 31 when no arc is generated in either of the solar battery strings 11a and 11b. Fig. 4b is a waveform chart illustrating an FFT processing waveform of a current sensed by the current sensor 31 when an arc is generated in any of the solar battery strings 11a and 11b.

The solar battery strings 11a and 11b generate power of a direct current. The power generated by the solar battery strings 11a and 11b is input to the PCS 13 via the string optimizer 22. In this case, a direct current output from the solar battery strings 11a and 11b is blocked by the capacitors 19 and 20 and does not flow in the bypass current routes 23 and 24. In the PCS 13, direct current power input via the string optimizer 22 is converted into alternating current power and is output.

Here, when no arc is generated in either of the solar battery strings 11a and 11b, the waveform of an alternating current in the preceding stage (solar battery strings 11a and 11b side) of the string optimizer 22 turns into a waveform in the non-arc generative state as illustrated in Fig. 3a. Therefore, a current sensed by the current sensor 31 contains no alternating current of an arc. Fig. 4a illustrates the waveform of this current subjected to FFT processing by the FFT processing part 51.

Meanwhile, when an arc is generated in any of the solar battery strings 11a and 11b, the waveform of an alternating current in the preceding stage (solar battery strings 11 a and 11b side) of the string optimizer 22 turns into a waveform in the arc generative state as illustrated in Fig. 3a. In this case, although no alternating current of an arc flows in the string optimizer 22, an alternating current of an arc flows from the power line 17a to the power line 18a via the bypass current route 23, the power line 17b, the PCS 13, the power line 18b, the bypass current route 24, the power line 18c, the power line 17c, and the bypass current route 72a. Therefore, the waveform of an alternating current in the succeeding stage (PCS 13 side) of the string optimizer 22 turns into a waveform in the arc generative state as illustrated in Fig. 3b. In addition, an alternating current of an arc is sensed by the current sensor 31 provided in the power line 18b.

Therefore, a current sensed by the current sensor 31 contains an alternating current of an arc. Fig. 4b illustrates the waveform of this current subjected to FFT processing by the FFT processing part 51. Accordingly, the arc detection processing part 32 can detect generation of an arc in the solar battery strings 11a and 11b based on a high frequency component of a signal input from the current sensor 31.

(Advantage of Arc Detection Apparatus 61)

As described above, the arc detection apparatus 61 includes the bypass current routes 23, 24, and 72a with respect to the string optimizer 22 in the solar battery strings 11a and 11b in which the string optimizer 22 is provided. In addition, the capacitors 19, 20, and 71 a are respectively provided in the bypass current routes 23, 24, and 72a, and the current sensor 31 is provided in the power line 18b between the string optimizer 22 and the PCS 13. Therefore, even when the string optimizer 22 is present in the photovoltaic power generation system 1, the current sensor 31 can sense an alternating current of an arc generated in the solar battery strings 11a and 11b.

(Impedance of Capacitors 19, 20, and 71a)

In Fig. 1, the internal impedance of the string optimizer 22 and the internal impedance of the PCS 13 on the input side are illustrated in an equivalent circuit. As illustrated in Fig. 1, the string optimizer 22 has an impedance $Z_{in1}$ between the power lines 17a and 18a on the input side, an impedance $Z_{in2}$ between the power lines 17c and 18c on the input side, an impedance $Z_{out}$ between the power lines 17b and 18b on the output side, an impedance $Z_1$ between the power lines 17a and 17b on the positive side, an impedance $Z_2$ between the power lines 18a and 18b on the negative side, and an impedance $Z_3$ between the power lines 18a and 17c adjacent to each other. In addition, the PCS 13 has an impedance $Z_{PCSin}$ between the power lines 17b and 18b on the input side. Other impedances in the PCS 13 are not illustrated. Moreover, the impedances of the capacitors 19, 20, and 71a are $Z_{pass1}$, $Z_{pass2}$, and $Z_{pass3}$ respectively.

In order for the current sensor 31 to detect the alternating current of an arc generated in the solar battery string 11 a, it is desirable that the amount of an alternating current flowing from the power line 17a to the power line 18a via the impedances $Z_{pas1}$ and $Z_1$, via the impedances $Z_{out}$ and $Z_{PCSin}$, via the impedances $Z_{pass2}$ and $Z_2$, via the solar battery string 11b, and via the impedances $Z_{pass3}$ and $Z_3$ be greater than the amount of an alternating current flowing from the power line 17a to the power line 18a via the impedance $Z_{in1}$.

Similarly, in order for the current sensor 31 to detect the alternating current of an arc generated in the solar battery string 11b, it is desirable that the amount of an alternating current flowing from the power line 17c to the power line 18c via the impedances $Z_{pass3}$ and $Z_3$, via the solar battery string 11a, via the impedances $Z_{pass1}$ and $Z_1$, via the impedance $Z_{out}$ and $Z_{PCSin}$, and via the impedances $Z_{pass2}$ and $Z_2$ be greater than the amount of an alternating current flowing from the power line 17c to the power line 18c via the impedance $Z_{in2}$.

That is, it is desirable that the following Conditional Expression (1) be satisfied.

$$(\text{joint impedance constituted of } Z_{pass1}, Z_1, Z_{out}, Z_{PCSin}, Z_{pass2}, Z_2, Z_{pass3}, \text{ and } Z_3) =$$

$$\{(1/Z_{pass1})+(1/Z_1)\}^{-1}+\{(1/Z_{pass2})+(1/Z_2)\}^{-1}+\{(1/Z_{pass3})+(1/Z_3)\}^{-1}+\{(1/Z_{out})+(1/Z_{PCSin)}\}^{-1} \leq$$

$$Z_{in1}, Z_{in2} \dots (1)$$

In addition, in order for the current sensor 31 to detect the alternating current of an arc, it is desirable that the amount of an alternating current flowing from the power line 17b to the power line 18b via the impedance $Z_{PCSin}$ be greater than the amount of an alternating current flowing in the impedance $Z_{out}$. That is, it is desirable that the following Expression (2) be satisfied.

$$Z_{PCSin} \leq Z_{out} \dots (2)$$

Therefore, for example, the impedances $Z_{in1}$, $Z_{in2}$, $Z_{out}$, $Z_1$, $Z_2$, and $Z_3$ in the string optimizer 22, and the impedance $Z_{PCSin}$ in the PCS 13 can be measured using an LCR meter, and the impedances $Z_{pass1}$, $Z_{pass2}$, and $Z_{pass3}$ of the capacitors 19, 20, and 71 a can be easily determined using the measurement result and the Conditional Expression (1). In addition, for example, a capacitor may be provided between the power line 17b and the power line 18b on the PCS 13 side of the current sensor 31 such that the Expression (2) is satisfied using the measurement result.

Moreover, with reference to the Conditional Expression (1), when $Z_2 << Z_{in1}$ and $Z_{in2}$, it is possible to understand that the impedance $Z_{pass2}$ may have any value. Therefore, when the impedance $Z_2$ is extremely smaller than the impedances $Z_{in1}$ and $Z_{in2}$, the capacitor 20 having the impedance $Z_{pass2}$ can be omitted.

Incidentally, depending on the string optimizer 22, the solar battery strings 11a and 11b are connected in series or parallel, or both the series connection and the parallel connection can be realized. On the other hand, it is possible to exhibit the effects described above regardless of which of the series connection and the parallel connection is applied to the arc detection apparatus 61 of the present embodiment.

[Embodiment 2]

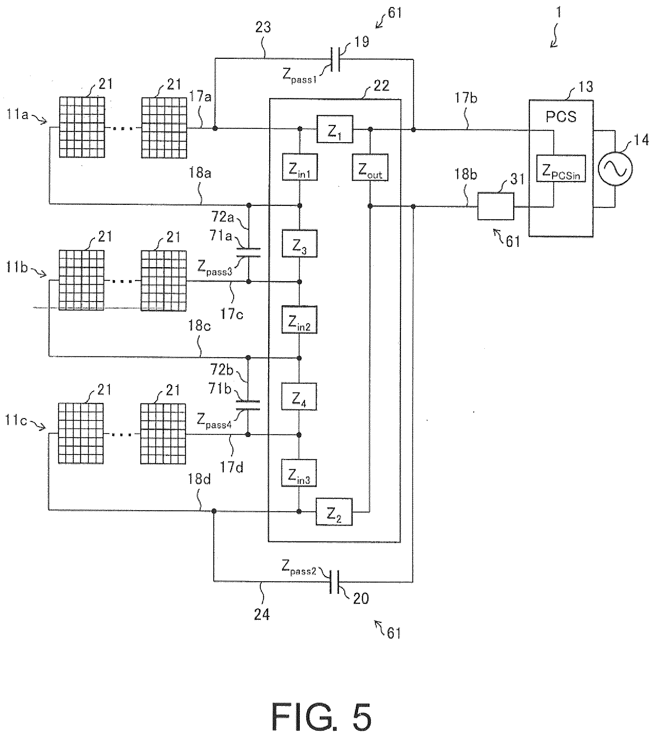

Fig. 5 is a schematic circuit diagram illustrating a configuration of the photovoltaic power generation system including an arc detection apparatus according to another embodiment of the present invention. As illustrated in Fig. 5, the photovoltaic power generation system 1 of the present embodiment is different from the photovoltaic power generation system 1 illustrated in Figs. 1 to 4 in that a new solar battery string 11c is connected to the string optimizer 22 through a power line 17d on the P-side and a power line 18d on the N-side serving as a pair of power circuits, and a bypass current route 72b and a capacitor 71b are added to the arc detection apparatus 61. Other configurations are similar.

In the bypass current route 72b, a first end portion (one end portion) is connected to the power line 18c between the string optimizer 22 and the solar battery string 11b, and a second end portion (the other end portion) is connected to the power line 17d (one of the pair of second power lines) between the string optimizer 22 and the solar battery string 11c, such that the bypass current route 72b bypasses the string optimizer 22.

The capacitor 71b (inter-power source capacitor) is provided in the bypass current route 72b. That is, in the capacitor 71b, a first electrode is connected to the power line 18c, and a second electrode is connected to the power line 17d, thereby forming the bypass current route 72b.

In the case of the configuration described above, as illustrated in Fig. 5, an impedance $Z_{in3}$ between the power lines 17d and 18d on the input side, and an impedance $Z_4$ between the power lines 18c and 17d adjacent to each other are added to the string optimizer 22. The impedance of the capacitor 71b is $Z_{pass4}$.

In the configuration described above, in order for the current sensor 31 to detect the alternating current of an arc generated in the solar battery string 11a, it is desirable that the amount of an alternating current flowing from the power line 17a to the power line 18a via the impedances $Z_{pass1}$ and $Z_1$, via the impedances $Z_{out}$ and $Z_{PCSin}$, via the impedances $Z_{pass2}$ and $Z_2$, via the solar battery string 11c, via the impedances $Z_{pass4}$ and $Z_4$, via the solar battery string 11b, and via the impedances $Zp_{ass3}$ and $Z_3$ be greater than the amount of an alternating current flowing from the power line 17a to the power line 18a via the impedance $Z_{in1}$.

Similarly, in order for the current sensor 31 to detect the alternating current of an arc generated in the solar battery string 11b, it is desirable that the amount of an alternating current flowing from the power line 17c to the power line 18c via the impedances $Z_{pass3}$ and $Z_3$, via the solar battery string 11a, via the impedances $Z_{pass1}$ and $Z_1$, via the impedances $Z_{out}$ and $Z_{PCSin}$, via the impedances $Z_{pass2}$ and $Z_2$, via the solar battery string 11c, and via the impedances

$Z_{pass4}$ and $Z_4$ be greater than the amount of an alternating current flowing from the power line 17c to the power line 18c via the impedance $Z_{in2}$.

Similarly, in order for the current sensor 31 to detect the alternating current of an arc generated in the solar battery string 11c, it is desirable that the amount of an alternating current flowing from the power line 17d to the power line 18d via the impedances $Z_{pass4}$ and $Z_4$, via the solar battery string 11b, via the impedances $Z_{pass3}$ and $Z_3$, via the solar battery string 11a, via the impedances $Z_{pass1}$ and $Z_1$, via the impedances $Z_{out}$ and $Z_{PCSin}$, and via the impedances $Z_{pass2}$ and $Z_2$ be greater than the amount of an alternating current flowing from the power line 17d to the power line 18d via the impedance $Z_{in3}$.

That is, it is desirable that the following Conditional Expression (3) be satisfied.

$$\text{(joint impedance constituted of } Z_{pass1}, Z_1, Z_{out}, Z_{PCSin}, Z_{pass2}, Z_2, Z_{pass3}, Z_3, Z_{pass4}, \text{ and } Z_4) =$$

$$\{(1/Z_{pass1})+(1/Z_1)\}^{-1}+\{(1/Z_{pass2})+(1/Z_2)\}^{-1}+\{(1/Z_{pass3})+(1/Z_3)\}^{-1}+\{(1/Z_{pass4})+(1/Z_4)\}^{-1}+\{(1/Z_{out})+(1/Z_{PCSin})\}^{-1} \le Z_{in1}, Z_{in2}, Z_{in3} \ldots (3)$$

Therefore, the number of solar battery strings connected to the string optimizer 22 via a pair of power lines may be two as illustrated in Fig. 1, may be three as illustrated in Fig. 5, or may be four or more.

In addition, for example, the impedances $Z_{in1}$, $Z_{in2}$, $Z_{in3}$, $Z_{out}$, $Z_1$, $Z_2$, $Z_3$, and $Z_4$ between terminals in the string optimizer 22, and the impedance $Z_{PCSin}$ in the PCS 13 can be measured using an LCR meter, and the impedances $Z_{pass1}$, $Z_{pass2}$, $Z_{pass3}$, and $Z_{pass4}$ of the capacitors 19, 20, 71a, and 71b can be easily determined using the measurement result and the Conditional Expression (3).

[Embodiment 3]

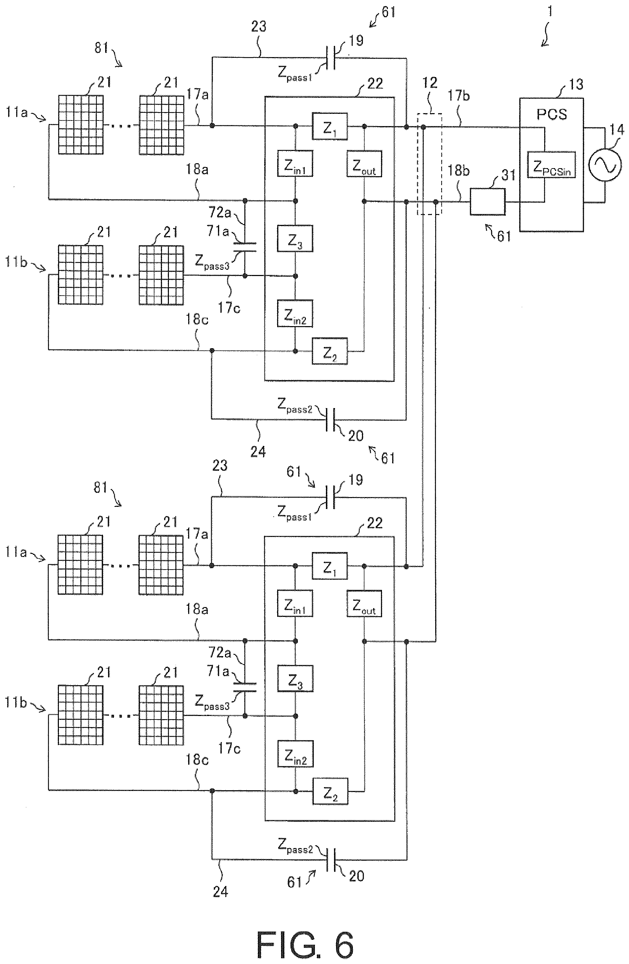

Fig. 6 is a schematic circuit diagram illustrating a configuration of the photovoltaic power generation system including an arc detection apparatus according to further another embodiment of the present invention. The photovoltaic power generation system 1 illustrated in Fig. 6 is different from the photovoltaic power generation system 1 illustrated in Figs. 1 to 4 in that two string parts 81 each including the solar battery strings 11a and 11b and the string optimizer 22 illustrated in Fig. 1 are provided, and a connection box 12 is provided. Other configurations are similar.

The two string parts 81 and 81 are connected to the connection box 12, and the connection box 12 is connected to the PCS 13. In the connection box 12, the two string parts 81 and 81 are connected in parallel.

As in the configuration above, the photovoltaic power generation system 1 may include a plurality of string optimizers 22. In this case, the bypass current routes 23, 24, and 72a bypassing the string optimizer 22 are provided for each of the string optimizers 22, and the capacitors 19, 20, and 71a are respectively provided in the bypass current routes 23, 24, and 72a. Accordingly, the current sensor 31 can sense an alternating current of an arc generated in any of the four solar battery strings 11a, 11a, 11b, and 11b. As a result, the arc detection apparatus 61 can detect generation of an arc in any of the four solar battery strings 11a, 11a, 11b, and 11b.

[Embodiment 4]

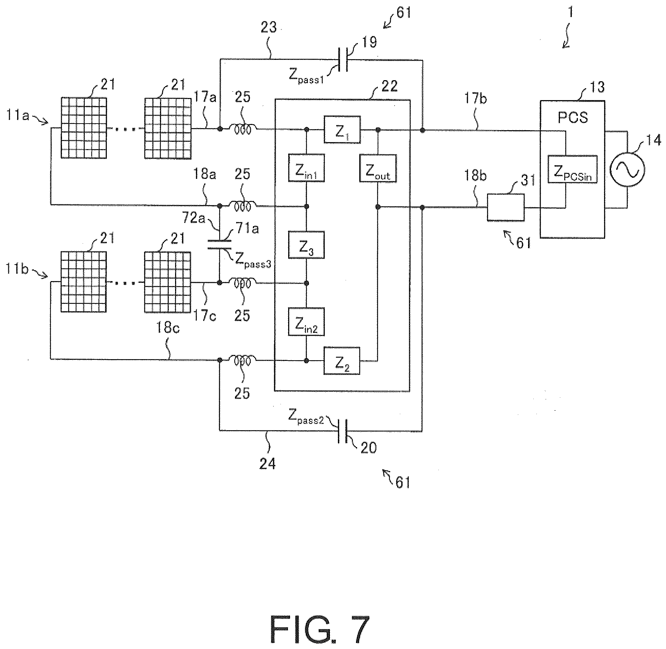

Fig. 7 is a schematic circuit diagram illustrating a configuration of the photovoltaic power generation system including an arc detection apparatus according to an alternative embodiment of the present invention. As illustrated in Fig. 7, the photovoltaic power generation system 1 of the present embodiment is different from the photovoltaic power generation system 1 illustrated in Figs. 1 to 4 in that a coil 25 is newly provided in each of the power lines 17a, 18a, 17c, and 18c on the input side of the string optimizer 22. Other configurations are similar.

In the present embodiment, in the bypass current route 23, a first end portion (connection portion) is connected to the power line 17a between the coil 25 and the solar battery string 11a, and a second end portion is connected to the power line 17b between the string optimizer 22 and the current sensor 31, such that bypass current route 23 bypasses the coil 25 and the string optimizer 22. Similarly, in the bypass current route 24, a first end portion is connected to the power line 18c between the coil 25 and the solar battery string 11b, and a second end portion is connected to the power line 18b between the string optimizer 22 and the PCS 13, such that the bypass current route 24 bypasses the coil 25 and the string optimizer 22.

In addition, in the bypass current route 72a, a first end portion (connection portion) is connected to the power line 18a between the coil 25 and the solar battery string 11 a, and a second end portion (connection portion) is connected to the power line 17c between the coil 25 and the solar battery string 11b, such that the bypass current route 72a bypasses the coils 25 and 25, and the string optimizer 22.

When the four coils 25 are added, the amount of an alternating current flowing from the power line 17a to the power line 18a via the coil 25, the impedance $Z_{in1}$, and the coil 25 is reduced. In addition, the amount of an alternating current flowing from the power line 17c to the power line 18c via the coil 25, the impedance $Z_{in2}$, and the coil 25 is reduced. In addition, the amount of an alternating current flowing from the power line 17c to the power line 18a via the coil 25, the impedance $Z_3$, and the coil 25 is reduced.

Therefore, the amount of an alternating current flowing in the bypass current routes 23, 24, and 72a increases, and the amount of an alternating current flowing in the current sensor 31 increases. As a result, it is possible to accurately detect generation of an arc. The coils 25 may be mounted inside an input portion of the string optimizer 22. In addition, when the capacitor 20 can be omitted as described above, the coil 25 provided in the power line 18c may be omitted.

(Supplementary Information)

In the embodiments, the bypass current routes 23, 24, 72a, and 72b, and the capacitors 19, 20, 71a, and 71b are provided outside the string optimizer 22. However, the bypass current routes and the capacitors may be provided inside the string optimizer 22.

In addition, in the embodiments, the present invention is applied to a photovoltaic power generation system. However, the present invention is not limited thereto and can be applied to an arbitrary power supply system including a direct current power source. In addition to a photovoltaic power generation apparatus, examples of direct current power sources include a fuel cell apparatus which can acquire electric energy (direct current power) by utilizing hydrogen fuel for electrochemical reaction between hydrogen fuel and oxygen in the air, a storage battery which stores electric energy, and an electric condenser such as a capacitor.

[Reference Signs List]

1 photovoltaic power generation system
11a-11c solar battery strings
13 power conditioning system
14 power system
17a-17d, 18a-18d power line
19, 20, 71a, 71b capacitor
22 string optimizer
23, 24, 72a, 72b bypass current route
25 coil
31 current sensor
32 arc detection processing part
41 amplifier
42 filter
43 A/D converter
44 central processing unit
51 FFT processing part
52 arc presence/absence determining part
61 arc detection apparatus
$Z_{in1}$-$Z_{in3}$, $Z_{out}$, $Z_1$-$Z_4$, $Z_{pass1}$-$Z_{pass4}$, $Z_{PCSin}$ impedance

**Claims**

1. An arc detection apparatus (61) applied to a direct current power supply system (1) comprising:

    a plurality of direct current power sources (11a, 11b) for power generation or charging/discharging;
    an optimizer (22) that optimizes output of the plurality of direct current power sources(11a,11b);
    a loading device (13) that consumes or converts output power of the optimizer (22);
    a plurality of pairs of first power lines (17a, 17c, 18a, 18c) that connect the plurality of direct current power sources (11a, 11b) and the optimizer (22); and
a pair of second power lines (17b, 18b) that connect the optimizer (22) and the loading device (13),
wherein each of the plurality of pairs of first power lines (17a, 17c, 18a, 18c) has an inter-power source capacitor (71a) of which one end portion is connected to one of a certain pair of first power lines (17a, 17c, 18a, 18c) and of which the other end portion is connected to one of a different pair of first power lines (17a, 17c, 18a, 18c), and
wherein the arc detection apparatus (61) comprises:

a first capacitor (19) of which one end portion is connected to one of the two first power lines (17a, 17c, 18a, 18c) having no inter-power source capacitor (71a) connected thereto and of which the other end portion is connected to one of the pair of second power lines (17b, 18b);
a current measuring part (31) which measures a current in the second power lines (17b, 18b), and
an arc determining part (52) which determines the presence or absence of an arc based on a high frequency component of an alternating current measured by the current measuring part (31).

2. The arc detection apparatus (61) according to claim 1,

wherein an impedance between the first capacitor (19) and the inter-power source capacitor (71a) satisfies a condition that a joint impedance constituted of the impedance between the first capacitor (19) and the inter-power source capacitor (71a), an impedance of the optimizer (22) between the two first power lines (17a, 17c, 18a, 18c) having no inter-power source capacitor (71a) connected thereto and the pair of second power lines (17b, 18b), an impedance of the optimizer (22) between the pair of second power lines (17b, 18b), an impedance of the loading device (13), and an impedance of the optimizer (22) between the first power lines (17a, 17c, 18a, 18c) each of which is provided with the inter-power source capacitor (71a) is smaller than any of the impedances of the optimizer (22) between each of the plurality of pairs of first power lines (17a, 17c, 18a, 18c).

3. The arc detection apparatus (61) according to claim 1 or 2, further comprising:

a plurality of coils each of which is provided between a connection portion of the first capacitor (19) in the first power lines (17a, 17c, 18a, 18c) and the inter-power source capacitor (71a), and an input portion of the optimizer (22).

4. The arc detection apparatus (61) according to any one of claims 1 to 3, further comprising:

a second capacitor (20) of which one end portion is connected to the other one of the two first power lines (17a, 17c, 18a, 18c) having no inter-power source capacitor (71a) connected thereto and of which the other end portion is connected to the other one of the pair of second power lines (17b, 18b).

5. The arc detection apparatus (61) according to claim 4,

wherein an impedance among the first capacitor (19), the second capacitor (20), and the inter-power source capacitor (71 a) satisfies a condition that a joint impedance constituted of the impedance among the first capacitor (19), the second capacitor (20), and the inter-power source capacitor (71a), the impedance of the optimizer (22) between the two first power lines (17a, 17c, 18a, 18c) having no inter-power source capacitor (71 a) connected thereto and the pair of second power lines (17b, 18b), the impedance of the optimizer (22) between the pair of second power lines (17b, 18b), the impedance of the loading device (13), and the impedance of the optimizer (22) between the first power lines (17a, 17c, 18a, 18c) each of which is provided with the inter-power source capacitor (71a) is smaller than any of the impedances of the optimizer (22) between each of the plurality of pairs of first power lines (17a, 17c, 18a, 18c).

6. The arc detection apparatus (61) according to claim 4 or 5, further comprising:

a coil (25) between a connection portion of the second capacitor (20) in the first power lines (17a, 17c, 18a, 18c) and the input portion of the optimizer (22).

FIG. 1

FIG. 2

EP 3 358 691 A1

NON-ARC
GENERATIVE STATE    ARC GENERATIVE STATE

CURRENT

TIME

## FIG. 3a

NON-ARC
GENERATIVE STATE    ARC GENERATIVE STATE

CURRENT

TIME

## FIG. 3b

FIG. 4a

FIG. 4b

FIG. 5

FIG. 6

FIG. 7

**EP 3 358 691 A1**

Europäisches
Patentamt

European
Patent Office

Office européen
des brevets

# EUROPEAN SEARCH REPORT

**Application Number**

EP 17 20 2104

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2014/055900 A1 (LUEBKE CHARLES JOHN [US] ET AL) 27 February 2014 (2014-02-27) | 1,3,4 | INV. H02H1/00 |
| A | * paragraphs [0030] - [0041]; figures 1,2,4 * | 2,5,6 | H02H7/26 H02J3/38 |
| A | US 2012/318320 A1 (ROBBINS STEVEN ANDREW [US]) 20 December 2012 (2012-12-20) * paragraphs [0031] - [0032]; figure 6 * | 1 | |
| A | KR 101 677 925 B1 (D2 ENG CO LTD [KR]) 29 November 2016 (2016-11-29) * abstract; figures 1,2 * | 2,5,6 | |

**TECHNICAL FIELDS SEARCHED (IPC)**

H02H
H02J
H02S

The present search report has been drawn up for all claims

| Place of search | Date of completion of the search | Examiner |
|---|---|---|
| Munich | 22 June 2018 | Colombo, Alessandro |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.....................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 20 2104

This annex lists the patent family members relating to the patent documents cited in the above-mentioned European search report.
The members are as contained in the European Patent Office EDP file on
The European Patent Office is in no way liable for these particulars which are merely given for the purpose of information.

22-06-2018

| Patent document cited in search report | Publication date | Patent family member(s) | Publication date |
|---|---|---|---|
| US 2014055900 A1 | 27-02-2014 | NONE | |
| US 2012318320 A1 | 20-12-2012 | NONE | |
| KR 101677925 B1 | 29-11-2016 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014509396 PCT
- JP 2010521720 PCT
- JP 2012510158 PCT